Europäisches Patentamt

European Patent Office

Office européen des brevets

(19)

(11) Veröffentlichungsnummer: **0 275 593**
**B1**

(12)

# EUROPÄISCHE PATENTSCHRIFT

(45) Veröffentlichungstag der Patentschrift:
18.07.90

(51) Int. Cl.⁵: **G01R 33/36**

(21) Anmeldenummer: 87202543.2

(22) Anmeldetag: **16.12.87**

(54) **Kernresonanzgerät mit Drehfelderzeugung und Detektion.**

(30) Priorität: **22.12.86 NL 8603253**

(43) Veröffentlichungstag der Anmeldung:
**27.07.88 Patentblatt 88/30**

(45) Bekanntmachung des Hinweises auf die Patenterteilung:
**18.07.90 Patentblatt 90/29**

(84) Benannte Vertragsstaaten:
**BE DE FR GB IT NL SE**

(56) Entgegenhaltungen:
**EP-A- 0 196 134**
**DE-A- 3 427 666**
**GB-A- 2 161 940**
**US-A- 4 594 566**

**JOURNAL OF MAGNETIC RESONANCE, Band 69, Nr. 2, September 1986, Seiten 236-242, Academic Press, Inc., New York, US; V.J. SANK et al.: "A quadrature coil for the adult human head"**

(73) Patentinhaber: **N.V. Philips' Gloeilampenfabrieken, Groenewoudseweg 1, NL-5621 BA Eindhoven(NL)**

(72) Erfinder: **Van Heelsbergen, Teunis Robert, c/o INT. OCTROOIBUREAU B.V. Prof. Holstlaan 6, NL-5656 AA Eindhoven(NL)**

(74) Vertreter: **Faessen, Louis Marie Hubertus et al, INTERNATIONAAL OCTROOIBUREAU B.V. 6 Prof. Holstlaan, NL-5656 AA Eindhoven(NL)**

## Beschreibung

Die Erfindung betrifft ein Kernresonanzgerät mit einer Anordnung zum Erzeugen und Detektieren hochfrequenter elektromagnetischer Felder, wobei die Anordnung einen Sender/Empfänger mit zwei Spulen und elektrischen Verbindungsmitteln zum Erzeugen von Hf-Magnetfeldern enthält.

Eine derartige Kernresonanzanordnung ist aus der EP-Patentanmeldung 0 114 405 bekannt. Dabei sind zum Senden und Empfangen von Hochfrequenzsignalen zwei getrennte Spulensysteme verwendet. Zum Vermeiden gegenseitiger Beeinflussung zwischen einer Hochfrequenzsendespule und einer Hochfrequenzdetektionsspule ist eine Entkoppelschaltung erforderlich, mit der beispielsweise der Kreis, von dem die Sendespule ein Teil ist, bei der Aktivierung der Sendespule auf eine wesentlich höhere Eigenfrequenz eingestellt wird. Zum andern kann die Sendespule bei der Detektion durch die Empfangsspule durch eine niederohmige Kurzschlussschaltung kurzgeschlossen werden, wodurch eine Störung der zu empfangenden Hochfrequenzsignale vermieden wird. In dem Buch "Nuclear Magnetic Resonance Imageing", herausgegeben vom Saunder's Company in Philadelphia im Jahre 1983, wird beschrieben, dass die Sendespule und die Empfangsspule zu einer kombinierten Empfangssendespule zusammengefügt werden können. Dabei treten selbstverständlich die vorgenannten Probleme nicht auf. Bei der Verwendung von zwei senkrecht zueinander verlaufenden Spulensystemen kann ein Drehfeld erzeugt werden. Dabei müssen die Speisepunkte dieser Spulensysteme über eine 1/4-λ-Leitung verbunden werden, damit die Signale in der entsprechenden Phase jeder Spule zugeleitet werden. Jedoch sind die Speisepunkte zum Ansteuern und Empfangen derartiger Spulensysteme nicht dieselben, so dass zwei Speiseanschlusspunkte erforderlich sind. Wenn ein Punkt an den Sender angeschlossen ist, soll der andere Punkt vom Empfänger entkoppelt sein. So gilt weiter, dass beim Anschliessen des Empfängers an den zweiten Speisepunkt, der Sender vom ersten Speisepunkt entkoppelt sein soll. Diese Umstände erfordern ein schnelles Umschalten. Dies ist insbesondere schwierig, wenn die Kombination in ein Kernspinresonanzgerät aufgenommen ist. Das bedeutet, dass hierfür keine normalen Schalter verwendet werden können. Aus Dokument EP-A 0 196 134 ist auch ein Kernresonanzgerät bekannt, in dem ein erster Speiseanschlusspunkt einer Spule über eine 1/4 Leitung mit einem zweiten Speiseanschlusspunkt verbunden ist an den die andere Spule angeschlossen ist. Die Erfindung geht aus von einem Gerät nach dem Oberbegriff des Anspruchs 1.

Der Erfindung liegt die Aufgabe zugrunde, ein Kernresonanzgerät zu schaffen, in dem mit demselben Spulensystem Hochfrequenzdrehfelder sowohl erzeugt als auch detektiert werden, wobei keine mechanischen Schaltkontakte zum An- oder Entkoppeln von Speisepunkten beim Sender oder beim Empfänger erforderlich sind.

Zur Lösung dieser Aufgabe ist ein Kernresonanzgerät erfindungsgemäss dadurch gekennzeichnet, dass der erste bzw. zweite Speiseanschlusspunkt über Phasendrehungsverbindungsmittel mit einem ersten bzw. zweiten Knotenpunkt verbunden sind, die über Verbindungsmittel an den Sender/Empfänger angeschlossen sind und dass beim Senden des Senders bzw. beim Empfangen im Empfänger der erste Knotenpunkt vom zweiten Knotenpunkt mit elektrischen Mitteln entkoppelt ist.

Ausführungsbeispiele der Erfindung werden nachstehend an Hand der Zeichnung näher erläutert. Es zeigen

Fig. 1 ein erfindungsgemässes Kernspinresonanzgerät,
Fig. 2 ein Sende/Empfangsspulensystem,
Fig. 3 ein Ausführungsbeispiel für den Anschluss eines Sende/Empfangsspulensystems, und
Fig. 4 ein bevorzugtes Ausführungsbeispiel für den Anschluss eines Sende-Empfangsspulensystem.

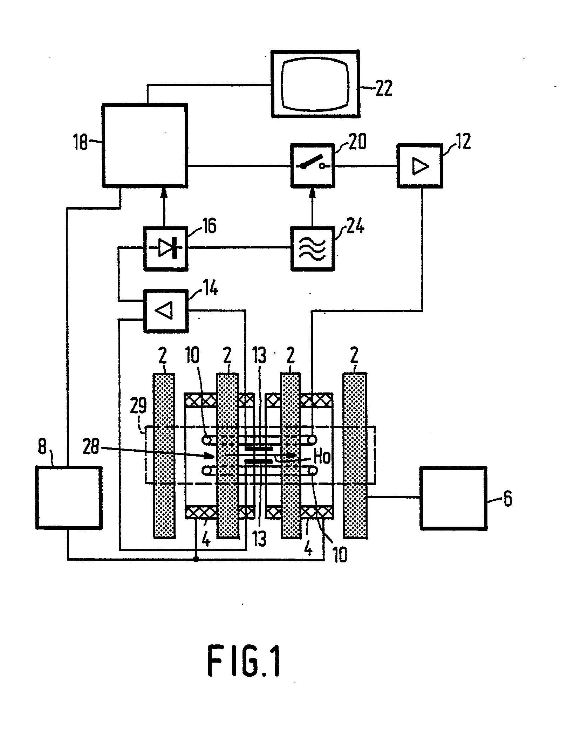

Ein Kernresonanzgerät nach der Darstellung in Fig. 1 enthält ein Magnetsystem 2 zum Erzeugen eines stationären, homogenen Magnetfelds HO, ein Magnetsystem 4 zum Erzeugen magnetischer Gradientenfelder, Speisequellen 6 und 8 für das Magnetsystem 2 bzw. das Magnetsystem 4. Eine Magnetspule 10 dient zum Erzeugen eines hochfrequenten magnetischen Wechselfeldes und ist dazu an eine Hochfrequenzquelle 12 angeschlossen. Für die Detektion der vom Hochfrequenzsendefeld in einem zu untersuchenden Objekt erzeugten Kernresonanzsignale ist eine Detektionsspule 13 vorgesehen. Zum Lesen ist die Detektionsspule 13 mit einem Signalverstärker 14 verbunden. Der Signalverstärker 14 ist an einen phasenempfindlichen Gleichrichter 16 angeschlossen, der mit einer zentralen Steuer- und Verarbeitungsanordnung 18 verbunden ist. Die zentrale Steuer- und Verarbeitungsanordnung 18 steuert weiter einen Modulator 20 für die Hochfrequenzquelle 12, die Speisequelle 8 für die Gradientenspulen und einen Monitor 22 für die Bildwiedergabe. Ein Hochfrequenzoszillator 24 steuert sowohl den Modulator 20 als auch den Messignale verarbeitenden phasenempfindlichen Gleichrichter 16. Die in den Magnetsystemen 2 und 4 angeordnete Sendespule 10 schliesst einen Messraum 28 ein, der bei einem Gerät für medizinische diagnostische Messungen zum Aufnehmen von Patienten innerhalb von weit zu bemessenden Umfangsgrenzen gross genug ist. Im Messraum 28 können also ein homogenes Magnetfeld HO, für Positionswahl darzustellender Schnitte erforderliche Gradientenfelder und ein räumlich homogenes Hochfrequenzwechselfeld erzeugt werden. Im Raum 28 kann die Detektionsspule 13 angeordnet werden.

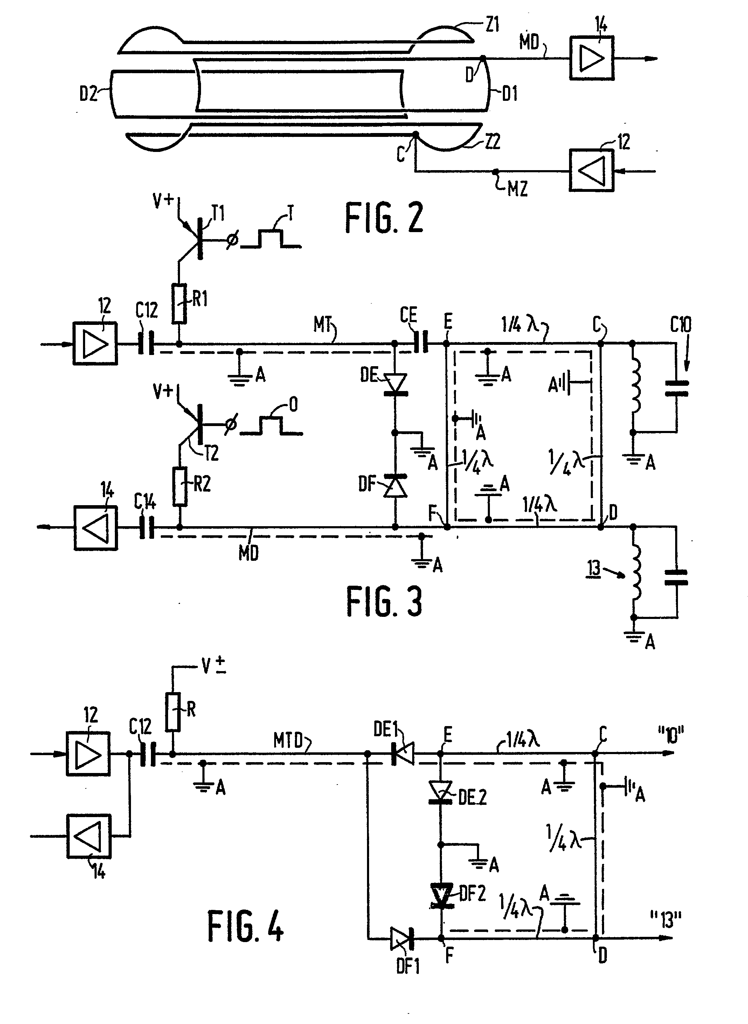

In Fig. 2 sind die Sendespulen 10 und die Detektionsspule 13 in einigermassen perspektivischer Darstellung in einer gegenseitigen Lage dargestellt. Die hier dargestellte gegenseitige Orientierung sei der Einfachheit halber als senkrechte Orientierung bestimmt, weil hier durch die Windungen der Sendespule und der Detektionsspule bestimmte Flächen im wesentlichen senkrecht zueinander verlaufen. Die Sendespule 10 enthält zwei Wicklungen Z1 und Z2, die an die Hochfrequenzquelle 12 angeschlossen sind. Die Detektionsspule 13 enthält zwei Wicklungen D1 und D2, die an den Signalverstärker 14 angeschlossen sind. Normalerweise sind die Verbindungsmittel MZ und MD zwischen dem Sender 12 und dem Detektor 14 Koaxialkabel, die ununterbrocken für den Sender 12 und die Sendespule 10 sowie für den Detektor 14 und die Detektionsspule 13 zur Verfügung stehen derart, dass die Sendespule 10 nur senden und die Detektionsspule 13 nur empfangen kann. Jetzt ist es auch möglich, mit der dargestellten Spulenkonfiguration Hf-Drehfelder zu erzeugen und zu detektieren, wenn die Speiseanschlusspunkte C und D über eine λ/4-Leitung (Koaxialkabel) verbunden werden und sowohl in die Leitung MZ als auch in die Leitung MD Schalter aufgenommen werden. Bei geöffnetem Schalter in der Leitung MD kann mit dem Sender 12 ein Hf-Drehfeld mittels der vier Wicklungen Z1, Z2, D1 und D2 erzeugt werden. Wird anschliessend der Schalter in der Leitung MZ geöffnet und der Schalter in der Leitung MD geschlossen, können mit den vier Wicklungen Z1, Z2, D1 und D2 und mit dem Detektor 14 Hf-Drehfelder detektiert werden, die von im Hf-Sendefeld erzeugten Kernresonanzsignalen erzeugt werden. Das Umschalten der Schalter in den Leitungen MZ und MD wird als störend empfunden, weil dies rasch erfolgen soll (ms) und auch in Anwesenheit von Magnetfeldern (siehe Fig. 1).

In Fig. 3 ist ein Ausführungsbeispiel dargestellt, in dem die Funktionen der vorbeschriebenen Schalter teilweise durch PIN-Dioden ersetzt sind, die durch Steuerspannungen in einen gesperrten oder leitenden Zustand gebracht werden. Weiter enthält die Schaltung in Fig. 3 phasendrehende Verbindungsmittel zwischen den Speisepunkten C und D einerseits und den Knotenpunkten E und F andererseits. Zwischen den Punkten C und E, D und F und E und F sind λ/4-Leitungen verlegt, die je eine Phasendrehung von 90° (im Idealfall) bewirken (der Vollständigkeit halber sei erwähnt, dass die charakteristische Impedanz der drei letztgenannten λ/4-Leitungen die Hälfte der charakteristischen Impedanz der λ/4-Leitung zwischen den Punkten C und D beträgt). Die Abschirmmantel der λ/4-Leitungen, und der Verbindungsmittel MT und MD sind an in der Figur mit A bezeichneten Stellen mit Masse verbunden.

Wenn der Sender 12 im Betrieb ist, sind die an den Punkten E und D erzeugten Spannungen entgegengesetzt. Die Spannung am Punkt F beträgt im Idealfall dabei Null Volt. Der Punkte F könnte an Masse A gelegt werden, ohne dass der Sender 12 oder die Sende- oder Empfangsspule 10 oder 13 dabei gestört werden. Auch liefern die beim Empfang auftretenden Spannungen ( von den Spulen 10 und 13 detektierte Resonanzsignale), wenn der Sender 12 nicht im Betrieb ist, an den Punkten C und F entgegengesetzte Spannungen. Hierdurch führt der Punkt E im Idealfall keine Spannung. Der Idealfall wird nur dann erreicht, wenn

a) die Leitungen alle genau λ/4 lang sind,
b) die λ/4-Leitungen verlustfrei sind,

c) die Spulen 10 und 13 genau die charakteristische Impedanz der Leitungen besitzen,
d) die charakteristische Impedanz der λ/4-Leitungen exakt ist.

In der Praxis wird dies nicht verwirklichbar sein; daher wird der Knotenpunkt F über die Diode DF an Masse A gelegt, wenn der Sender 12 im Betrieb ist. Dazu wird der Basis des Transistors T2 eine Steuerspanung O zugeführt, die die Leitung MD über einen Widerstand R2 mit einer Gleichspannungsquelle V+ verbindet, so dass die PIN-Diode DF leitet und den Knotenpunkt F mit Masse A verbindet. Die Kapazitäten C12 und CE sind dazu vorgesehen, den Sender 12 bzw. die Diode DE von der Gleichspannung V+ freizumachen. Beim Empfang beträgt das Steuersignal am Transistor T2 0 Volt, während die Basis des Transistors T1 eine Steuerspannung T empfängt, so dass dabei die Leitung MT über einen Widerstand R1 an die Speisequelle V+ angeschlossen wird und die PIN-Diode DE den Knotenpunkt E mit Masse A verbindet. Mit der Kapazität C12 wird der Empfänger 12 von der Speisquelle V+ getrennt.

In Fig. 4 ist ein bevorzugtes Ausführungsbeispiel für einen Anschluss eines Senders 12/Empfängers 14 an ein Spulensystem 10/13 (nicht dargestellt) gezeigt, wobei der Sender 12 an den Empfänger 14 über ein einziges Verbindungsmittel MTD (beispielsweise ein Koaxialkabel, dass genau so abgeschirmt ist wie in Fig. 3) angeschlossen ist. In der dargestellten Ausführungsform nach Fig. 4 ist die λ/4-Leitung zwischen den Knotenpunkten E und F überflüssig, wie weiter unten näher erläutert wird. Die λ/4-Leitungen zwischen den Punkten E und C, F und D und D und D sowie die Spulenkonfiguration 10 und 13, die an die Speiseanschlusspunkte C und D angeschlossen ist, bleibt ungeändert. Zwar ist das Ende des Kabels MTD einerseits über zwei parallel verbundene Serienschaltungen von je zwei PIN-Dioden mit Masse A verbunden, doch haben die Dioden DE1 und DF1 sowie die Dioden DE2 und DF2 einen entgegengesetzten Gleichrichtsinn, wobei keine der Reihenschaltungen DE1, DE2 und DF1, DF2 leitet.

Wird nunmehr über einen Widerstand R die Leitung MTD mit einer Speisespannung V- verbunden, leiten die Dioden DE1 und DF2, so dass der Punkt F an Masse A gelegt wird. Der Sender 12 kann in diesem Zustand im Betrieb sein. Gelangt an den Widerstand R anschliessend eine Speisespannung V+, leiten die PIN-Dioden DF1 und DE2. Der Knotenpunkt E ist jetzt mit Masse A verbunden und der Empfänger 14 empfängt über das Kabel MTD und die Diode DF1 (leitend) die mit den Spulen 10 und 13 detektierten Resonanzsignale. Es sei bemerkt, dass die Dioden DE1, DE2, DF1 und DF2 sowie die λ/4-Leitungen mit den Spulen 10 und 13 zu einer Einheit zusammengebaut werden können, die an ein Koaxkabel (MTD) anschliessbar ist, wodurch ein einfaches austauschbares Sende-/Empfangsspulensystem erhalten wird.

**Patentansprüche**

1. Kernresonanzgerät mit einer Anordnung zum Erzeugen und Detektieren hochfrequenter elektromagnetischer Felder, wobei die Anordnung einen Sender/Empfänger mit zwei Spulen und elektrischen Verbindungsmitteln zum Erzeugen vom Hf-Magnetfeldern enthält, in dem zum Erzeugen eines Hochfrequenzfeldes die mit den Spulen erzeugten Magnetfelder senkrecht zueinander verlaufen und ein erster Speiseanschlusspunkt (C) einer Spule (10) über eine λ/4-Leitung mit einem zweiten Speiseanschlusspunkt (D) verbunden ist, an den die andere Spule (13) angeschlossen ist, dadurch gekennzeichnet, dass der erste (C) bzw. zweite (D) Speiseanschlusspunkt über Phasendrehungsverbindungsmittel mit einem ersten (E) bzw. zweiten (F) Knotenpunkt verbunden sind, die über Verbindungsmittel (MT, MD) mit dem Sender/Empfänger (12, 13) verbunden sind, und dass beim Senden durch den Sender (12) bzw. beim Empfangen durch den Empfänger (13) der erste Knotenpunkt (E) vom zweiten Knotenpunkt (F) mit elektrischen Mitteln (DE, DF) entkoppelt ist.

2. Gerät nach Anspruch 1, dadurch gekennzeichnet, dass die Phasendrehungsverbindungsmittel λ/4-Leitungen sind.

3. Gerät nach Anspruch 1 oder 2, dadurch gekennzeichnet, dass die charakteristische Impedanz der λ/4-Leitung zwischen dem ersten und dem zweiten Speiseanschlusspunkt (C, D) das zweifache der charakteristischen Impedanz der 1/4-λ-Leitungen zwischen dem ersten bzw. dem zweiten Knotenpunkt (E, F) und dem ersten bzw. zweiten Speisepunkt (C, D) ist.

4. Gerät nach Anspruch 1 oder 2, dadurch gekennzeichnet, dass die elektrischen Mittel eine λ/4-Leitung sind, die den ersten mit dem zweiten Knotenpunkt verbindet, wobei der erste bzw. zweite Knotenpunkt mit dem Sender bzw. Empfänger verbunden ist.

5. Gerät nach Anspruch 2, 3 oder 4, dadurch gekennzeichnet, dass der erste und der zweite Knotenpunkt (E, F) über eine in der gleichen Leitungsrichtung geschaltete PIN-Diode (DE, DF) mit Masse verbunden sind, die durch eine einer Sende- bzw. Empfangsleitung (MZ, MD) des Senders (12) zum ersten Knotenpunkt (E) bzw. zum zweiten Knotenpunkt (F) des Empfängers (13) zuzuführende Spannung steuerbar sind.

6. Gerät nach Anspruch 5, dadurch gekennzeichnet, dass die Sende- bzw. Empfangsleitung (MZ, MD) über einen ersten bzw. zweiten Halbleiterschalter (T1, T2) mit einer Speisespannung (V+) verbunden ist, wobei der erste bzw. zweite Halbleiterschalter beim Empfangen bzw. beim Senden leitet.

7. Gerät nach Anspruch 1, 2, 3 oder 4, dadurch gekennzeichnet, dass der erste Knotenpunkt (E) über eine erste bzw. zweite PIN-Diode (DE1, DE2) an Sender (12) bzw. an Masse (A) liegt, dass der zweite Knotenpunkt (F) über eine dritte bzw. vierte PIN-Diode (DF1, DF2) mit dem Empfänger (13) bzw. mit Masse (A) verbunden ist, dass die Leitungsrichtungen der ersten und der dritten PIN-Diode und die Leitungsrichtungen der zweiten und der vierten PIN-Dioden entgegengesetzt sind, wobei sowohl die Reihenschaltung der ersten und der zweiten Diode als auch die Reihenschaltung der dritten und der vierten Diode nicht leiten.

8. Gerät nach Anspruch 7, dadurch gekennzeichnet, dass der erste und der zweite Knotenpunkt (E, F) über die erste und die dritte Diode (DE1, DF1) sowie über eine Koaxialleitung (MTD) mit dem Sender und dem Empfänger ver (12, 13) verbunden sind und dass über die Koaxialleitung die PIN-Dioden gesteuert werden.

9. Gerät nach Anspruch 8, dadurch gekennzeichnet, dass die Koaxialleitung des Senders und des Empfängers gleichstromgekoppelt und mit der Quelle koaxial positiv oder koaxial negativ verbindbar ist.

**Claims**

1. A magnetic resonance apparatus, comprising a device for generating and detecting RF electromagnetic fields, which device comprises a transmitter/receiver with two coils and electrical connection means for generating RF magnetic fields, wherein, in order to generate an RF field, the magnetic fields generated by the coils extend perpendicularly to one another and a first supply terminal (C) of a coil (10) is connected, via a λ/4 lead, to a second supply terminal (D) whereto the other coil (13) is connected, characterized in that the first (C) and the second supply terminal (D) are connected, via phase-shifting connection means, to a first (E) and a second junction (F), respectively, which junctions are connected to the transmitter/receiver (12, 13) via connection means (MT, MD), the first junction (E) being uncoupled from the second junction (F) by means of electrical means (DE, DF) during the transmission by the transmitter (12) and the reception by the receiver (13).

2. An apparatus as claimed in Claim 1, characterized in that the phase-shifting connection means are λ/4 leads.

3. An apparatus as claimed in Claim 1 or 2, characterized in that the characteristic impedance of the λ/4 lead between the first and the second supply terminal (C, D) amounts to twice the characteristic impedance of the 1/4 λ leads between the first and the second junction (E, F) and the first and the second supply terminal (C, D), respectively.

4. An apparatus as claimed in Claim 1 or 2, characterized in that the electrical means is formed by a λ/4 lead which connects the first junction to the second junction, the first and second junction being connected to the transmitter and the receiver, respectively.

5. An apparatus as claimed in Claim 2, 3 or 4, characterized in that the first and the second junction (E, F) are connected to ground via a PIN diode (DE, DF) which is connected in the same direction of conduction and which can be controlled by a voltage to be applied, via a transmission lead and a receiving lead (MZ, MD), of the transmitter (12) to the first junction (E) and to the second junction (F) of the receiver (13), respectively.

6. An apparatus as claimed in Claim 5, characterized in that the transmitter lead and the receiver lead (MZ, MD) are connected to a supply voltage (V+) via a first semiconductor switch and a second semiconductor switch (T1, T2), respectively, the first and the second semiconductor switch being conductive during reception and transmission, respectively.

7. An apparatus as claimed in Claim 1, 2, 3 or 4, characterized in that the first junction (E) is connected, via a first and a second PIN diode (DE1, DE2), respectively, to the transmitter (12) and to ground (A), respectively, the second junction (F) being connected to the receiver (13) and to ground (A), respectively, via a third and a fourth PIN diode (DF1, DF2), respectively, the directions of conduction of the first and the third PIN diode being opposed and the directions of conduction of the second and the fourth PIN diode being opposed, the series connection of the first and the second diode as well as the series connection of the third and the fourth diode not being conductive.

8. An apparatus as claimed in Claim 7, characterized in that the first and the second junction (E, F) are connected, via the first and the third diode (DE1, DF1), to the transmitter and the receiver (12, 13) by means of a coaxial lead (MTD), the PIN diodes being controlled via the coaxial lead.

9. An apparatus as claimed in Claim 8, characterized in that the coaxial lead of the transmitter and the receiver is d.c. coupled and can be connected to the source in a coaxially positive or coaxially negative fashion.


**Revendications**

1. Appareil de résonance nucléaire comprenant un dispositif pour engendrer et détecter des champs électromagnétiques haute fréquence, le dispositif comprenant un émetteur/récepteur avec deux bobines et des moyens de liaison électriques pour créer des champs magnétiques haute fréquence, dans lequel, pour créer un champ haute fréquence, les champs magnétiques produits par les bobines sont perpendiculaires l'un à l'autre et un premier point de connexion d'alimentation (C) d'une bobine (10) est relié par une ligne λ/4 avec un deuxième point de connexion d'alimentation (D) auquel est connectée l'autre bobine (13), caractérisé en ce que le premier (C) et le deuxième (D) point de connexion d'alimentation sont reliés par des moyens de liaison à rotation de phase à un premier (E) et un deuxième (F) point nodal, qui sont reliés par des moyens de liaison (MT, MD) avec l'émetteur/récepteur (12, 13) et que, lors de l'émission à l'aide de l'émetteur (12) ou de la réception à l'aide du récepteur (13), le premier point nodal (E) est découplé du deuxième point nodal (F) par des moyens électriques (DE, DF).

2. Appareil suivant la revendication 1, caractérisé en ce que les moyens de liaison à rotation de phase sont des lignes λ/4.

3. Appareil suivant la revendication 1 ou 2, caractérisé en ce que l'impédance caractéristique de la ligne λ/4 entre le premier et le deuxième point de connexion de liaison (C, D) est le double de l'impédance caractéristique des lignes λ/4 entre le premier et le deuxième point nodal (E, F) et entre le premier et le deuxième point d'alimentation (C, D).

4. Appareil suivant la revendication 1 ou 2, caractérisé en ce que les moyens électriques sont une ligne λ/4 premier et le deuxième point nodal, tandis que le premier et le deuxième point nodal sont reliés respectivement à l'émetteur et au récepteur.

5. Appareil suivant la revendication 2, 3 ou 4, caractérisé en ce que le premier et le deuxième point nodal (E, F) sont mis à la masse par des diodes PIN (DE, DF) montées dans le même sens de conduction, qui peuvent être commandées par une tension qu'il faut amener par une ligne d'émission ou de réception (MZ, MD) de l'émetteur (12) au premier point nodal (E) ou au deuxième point nodal (F) du récepteur (13).

6. Appareil suivant la revendication 5, caractérisé en ce que la ligne d'émission ou de réception (MZ, MD) est connectée par un premier ou par un deuxième commutateur semi-conducteur (T1, T2) à une tension d'alimentation (V+), le premier et le second commutateur semi-conducteur étant respectivement conducteurs lors de la réception et lors de l'émission.

7. Appareil suivant la revendication 1, 2, 3 ou 4, caractérisé en ce que le premier point nodal (E) est connecté à l'émetteur (12) ou à la masse (A) par une première ou une deuxième diode PIN (DE1, DE2), que le deuxième point nodal (F) est connecté au récepteur (13) ou à la masse (A) par une troisième ou une quatrième diode PIN (DF1, DF2), que les sens de conduction de la première et de la troisième diode PIN et les sens de conduction de la deuxième et de la quatrième diode PIN sont opposés, tandis que le montage en série de la première et de la deuxième diode, et aussi le montage en série de la troisième et de la quatrième diode sont non conducteurs.

8. Appareil suivant la revendication 7, caractérisé en ce que le premier et le deuxième point nodal (E, F) sont reliés par la première et la troisième diode (DE1, DF1), ainsi que par une ligne coaxiale (MTD) à l'émetteur et au récepteur (12, 13) et que les diodes PIN sont commandées par la ligne coaxiale.

9. Appareil suivant la revendication 8, caractérisé en ce que la ligne coaxiale de l'émetteur et du récepteur est couplée en courant continu et peut être connectée coaxialement positive ou coaxialement négative à la source.

FIG.1

FIG. 2

FIG. 3

FIG. 4